# EUROPEAN PATENT APPLICATION

(11) **EP 4 040 452 A1**
(43) Date of publication of application: **10.08.2022**
(21) Application number: 22154121.2
(22) Date of filing: 29.01.2022
(51) Int. Cl.: H01C 1/142, H01C 7/00, H01C 17/00, H05K 1/02

(54) **HIGH FREQUENCY THIN FILM RESISTOR ASSEMBLY AND MANUFACTURING METHOD THEREOF**

(30) Priority: 05.02.2021 TW 110104449
(71) Applicant: Viking Tech Corporation, Hukou Township Hsin chu 303 (TW)
(72) Inventor: CHEN, Zhong-Yu, Hsinchu County (TW); CHIU, Cheng-Chung, Hsinchu County (TW); LU, Chi-Yu, Hsinchu County (TW)
(74) Representative: Schwerbrock, Florian

(57) **Abstract**

A thin film resistor assembly and its manufacturing method are proposed herein. The thin-film resistor assembly is to mount a flip-type thin-film resistor on a circuit board. The flip-type of thin-film resistor can reduce the parasitic induction, the parasitic capacitance and skin effect, therefore it significantly enhances the performance on high frequency.

## Description

### BACKGROUND OF THE INVENTION

### 1. FIELD OF THE INVENTION

The present invention relates to a thin-film resistor assembly and manufacturing method thereof, in particular to a high-frequency thin-film resistor assembly.

### 2. DESCRIPTION OF THE PRIOR ART

Generally, a thin-film resistor comprises a resistance layer disposed on a substrate, and the electrodes on the resistance layer. The electrode layer extends from the top surface to the bottom surface of the substrate, and then bottom electrodes are soldered on a circuit board to form a resistor assembly.

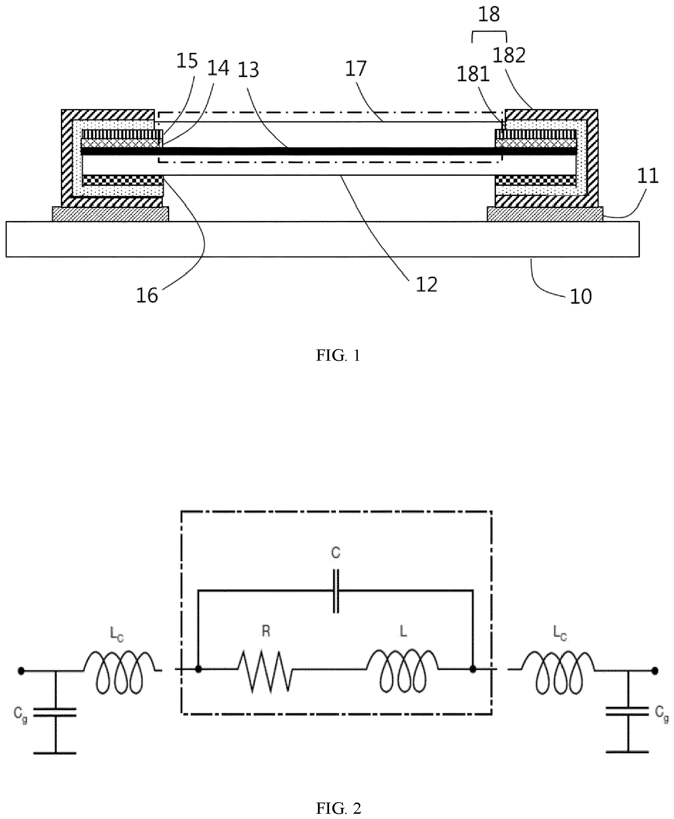

The resistor assembly, shown as FIG.1, the electrode layer extends from the top surface of the substrate, along the side surface, to the bottom surface, and FIG. 2 shows its equivalent circuit. A parasitic inductance and/or a parasitic capacitance exist(s) when current flows over the circuit, that is caused by the thickness of the substrate. Moreover, the top-surface current and bottom-surface current are parallel but in opposite to induce a skin effect, that increases its impedance as the frequency of the current-carried signal increases.

The present invention proposes solutions to reduce parasitic capacitance, parasitic inductance, and skin effect.

### SUMMARY OF THE INVENTION

The invention provides a high-frequency thin-film resistor assembly, which can reduce parasitic inductance and capacitance, and manufacturing method thereof.

A method of manufacturing a high-frequency thin-film resistor assembly comprises:
sequentially forming a resistance layer, an intermediate layer and a first electrode layer on a top surface of a substrate;
removing part of the first electrode layer, the intermediate layer and the resistance layer to form a first pattern;
removing part of the first electrode layer and the intermediate layer to form a second pattern and expose a part of the resistance layer;
forming a first protective layer on the part of the resistance layer; and
welding the first electrode layer to at least one metal contact of a circuit board to form the high-frequency thin-film resistor assembly.

A high-frequency thin-film resistor assembly comprises:
a substrate;
a resistance layer disposed on a top surface of a substrate with a first pattern;
an intermediate layer and a first electrode layer sequentially disposed on the
resistance layer with a second pattern to expose a part of the resistance layer;
a first protective layer disposed on the part of the resistance layer; and
a circuit board with at least one metal contact welded with the first electrode layer.

### BRIEF DESCRIPTION OF THE DRAWINGS

FIG. 1 is a side cross-sectional view of a general resistor assembly.
FIG. 2 is the circuit diagram of FIG. 1.
FIG. 3 is a side cross-sectional view of the high-frequency thin-film resistor assembly of the present invention.
FIG. 4 is the circuit diagram of FIG. 3.
FIG. 5 is a flow chart of the method for manufacturing the high-frequency thin-film resistor assembly of the present invention.
FIG. 6 is a result of the high frequency effect test.

### DESCRIPTION OF THE PREFERRED EMBODIMENTS

Various embodiments of the present invention will be described in detail as below, and the drawings will be used as examples to help readers to have a better understanding. In addition to these detailed descriptions, the present invention can also be widely implemented in other embodiments. Any substitutions, modifications, and equivalent changes of the embodiments should be understood to be included in the scope of the present invention. The scope of patents should be based on the scope of the claims. It should be noted that the drawings are for illustrative purposes only, and do not represent the actual size or quantity of the components. Some details may not be completely drawn in order to keep the drawings concise.

A resistance layer, at least one intermediate layer and an electrode layer are sequentially formed on a substrate, and then these metal layers are etched to a specific pattern. The resistor is flipped and mounted onto the circuit board.

The resistance layer and the electrodes are facing the circuit board for the flipped-and-mounted resistor assembly.

For the resistor assembly of the present invention, the current path doesn't pass the sides of the substrate, so the parasitic inductance and the parasitic capacitance, which constructs a parasitic LC circuit, are reduced. As a result, the interference of the parasitic LC circuit to the frequency decreases, so the thin-film resistor has a smaller impedance.

The resistance layer is closer to the circuit board, with respective to the conventional resistor, and the skin effect caused by parallel-but-opposite currents is also reduced, so the resistance value is more stable at high frequencies.

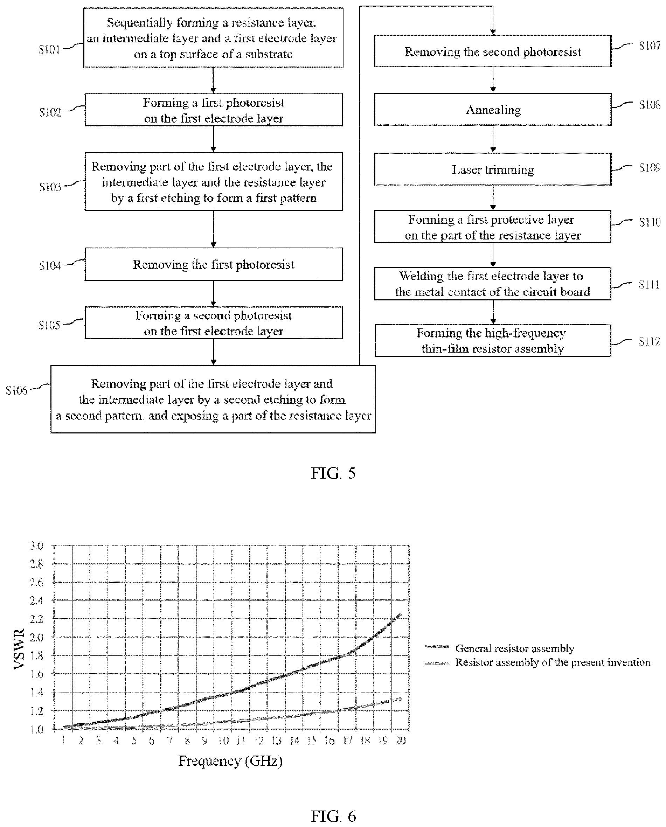

FIG. 5 shows the flow to manufacture the thin-film resistor assembly.

In step S101, a resistance layer, an intermediate layer, and a first electrode layer are sequentially formed on a top surface of a substrate and they are electrically connected. The known methods such as laminating, sputtering or printing processes and so on cab be used. Then an etching process accompanied with specific photoresist material is used to form a designed pattern. The substrate material can be alumina or other materials, which depends on the resistance layer.

S102-S104 show a first etching process. A first photoresist partially covers the first electrode layer. A first etching is following to remove the first electrode layer, the intermediate layer and the resistance layer to form a first pattern according to the first photoresist and then to remove the first photoresist. In these steps, it should make sure that no residual resistance layer on the periphery of the substrate to affect the quality. The first pattern is used to determine the resistance value.

S105-S107 show a second etching processing. A second photoresist partially covers on the first electrode layer, and the first electrode layer and the intermediate layer are etched to form a second pattern and then to remove the second photoresist. It is noted that the resistance layer is not etched to still have the first pattern to be partially exposed. The second etching agent includes 5~50% hydrochloric acid, 5~30% sulfuric acid, 5~30% nitrates, 1~10% fluoride, 1-5% interface active agent and 1~10% copper protective agent. Because the second etching agent is alkaline (mainly hydroxide), a low-concentration lye (about 20%), it doesn't basically react with the resistance layer. The photoresist is a kind of corrosion resistance, so the low-concentration lye cannot peel out the photoresist. The photoresist can protect the electrode layer and the immediate layer from the low-concentration lye to form the second pattern. The second pattern is designed according to the electrode connection pad to have a high quality electrical connection.

S108-S112 shows the steps of annealing, laser trimming resistance, and forming a first protective layer on the resistance layer. Finally, the first electrode is welded to the connection pads on the circuit board to form the thin-film resistor assembly.

In one embodiment, a second electrode layer can be formed on a bottom of the substrate and exposing a part of the bottom surface, an outer metal layer can be formed on the side of the substrate to connect between the first electrode layer and the second electrode layer. Optionally, a second protective layer is formed on the part of the bottom surface. In this embodiment, the outer metal layer or the second electrode layer can be used as the electrode pins.

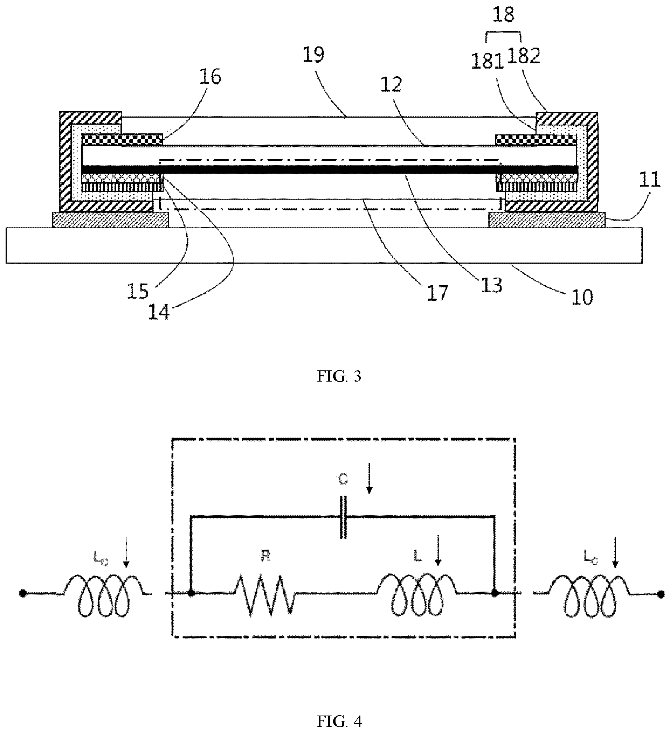

FIG. 3 is a side cross-sectional view, which shows a flip type of a thin-film resistor assembly of the present invention. The resistance layer 13 with the first pattern is on the top surface of the substrate 12 and facing the circuit board 10. Both of the intermediate layer 14 and the first electrode layer 15 with the second pattern are sequentially disposed on the resistance layer 13 to expose a part of the resistance layer. The part of the resistance layer is covered by the first protective layer 17. The first electrode layer 15 as the connection pin is welded on the metal contact 11 on the circuit board 10. The intermediate layer 14 and the electrode layer 15 with the second pattern cover the resistance layer 13 with the first pattern, and the covering area is about 75%-100% of the first pattern.

In one embodiment, a second electrode layer 16 is formed on a bottom surface of the substrate 12 to expose a part of the bottom surface, and an outer metal layer 18 is formed on a side surface of the substrate 12. The electrode layer 15, the second electrode layer 16 and the outer metal layer 18 are connected. A second protective layer 19 covers the part of the bottom surface. The second electrode layer 16 or the outer metal layer 8 can also be used as electrode pins.

The intermediate layer can be one or more transition metal layers, buffer layers with different materials or their combination. The intermediate is used to enhance the stability of the adhesion between the electrode layer and the resistance layer. As an embodiment, the outer metal layer 18 has a double-layer structure formed by a nickel layer 181 with a thickness of 4-10 µm and a tin layer 182 with a thickness of 6-14 µm. As another embodiment, the thickness of the intermediate layer is 300-500 Å of titanium, tungsten or their alloys. The thickness of the resistance layer is 300-900 angstroms (Å) and the material is nickel, chromium, silicon or a combination thereof. The thickness of the electrode layer is 3-15 µm and the material is silver, copper or a combination thereof.

The flip-type thin-film resistor assembly reduces the parasitic capacitance Cg, the parasitic inductance Lc, and the skin effect. The equivalent circuit is shown as FIG. 4. FIG. 6 shows the standing waves of the resistors (50 Ω) under passing the high-frequency signal for the invention and the conventional thin-film resistor. Regarding to the voltage standing wave ratio (VSWR), the thin-film resistor of the present invention is significantly lower than the conventional.

## Claims

1. A method for manufacturing a high-frequency thin-film resistor assembly, comprising:
sequentially forming a resistance layer, an intermediate layer and a first electrode layer on a top surface of a substrate;
removing part of the first electrode layer, the intermediate layer and the resistance layer to form a first pattern;
removing part of the first electrode layer and the intermediate layer to form a second pattern and expose a part of the resistance layer;
forming a first protective layer on the part of the resistance layer; and
welding the first electrode layer to at least one metal contact of a circuit board to form the high-frequency thin-film resistor assembly.

2. The method according to claim 1, before the step of welding, further comprising:
forming a second electrode layer on a bottom surface of the substrate and exposing a part of the bottom surface;
forming an outer metal layer on a side of the substrate to connect between the first electrode layer and the second electrode layer; and
forming a second protective layer on the part of the bottom surface.

3. A high-frequency thin-film resistor assembly, comprising:
a substrate;
a resistance layer disposed on a top surface of a substrate with a first pattern;
an intermediate layer and a first electrode layer sequentially disposed on the resistance layer with a second pattern to expose a part of the resistance layer;
a first protective layer disposed on the part of the resistance layer; and
a circuit board with at least one metal contact welded with the first electrode layer.

4. The resistor assembly according to claim 3, further comprising:
a second electrode layer is disposed on a bottom surface of the substrate to expose a part of the bottom surface;
an outer metal layer is disposed on a side of the substrate to connect between the first electrode layer and the second electrode layer; and
a second protective layer is disposed on the part of the bottom surface.

5. The resistor assembly according to claim 4, wherein the outer metal layer has a double-layer structure.

6. The resistor assembly according to claim 4, wherein the resistance layer is nickel, chromium, silicon or a combination thereof.

7. The resistor assembly according to claim 4, wherein the first electrode layer and the second electrode layer are copper, silver or a combination thereof.

8. The resistor assembly according to claim 4, wherein the outer metal layer is tin, nickel or a combination thereof.
